# FASCICULE DE BREVET EUROPEEN

(11) **EP 1 099 304 B1**
(45) Date de publication et mention de la délivrance du brevet: **27.03.2002**
(21) Numéro de dépôt: 99926229.8
(22) Date de dépôt: 08.07.1999
(51) Int. Cl.: H03H 3/00

(54) **DISPOSITIF DE REGLAGE AUTOMATIQUE D'UN COMPOSANT D'UNE CARTE ELECTRONIQUE, NOTAMMENT D'UN POTENTIOMETRE**
VORRICHTUNG ZUR AUTOMATISCHEN REGELUNG EINER KOMPONENTE VON EINER ELEKTRONISCHEN KARTE, INSBESONDERE EINES POTENTIOMETERS
DEVICE FOR AUTOMATICALLY ADJUSTING AN ELECTRONIC CARD COMPONENT, IN PARTICULAR A POTENTIOMETER

(30) Priorité: 09.07.1998 FR 9808969
(43) Date de publication de la demande: 16.05.2001
(73) Titulaire: Behbahanizadeh, Kambiz, 2300 La Chaux-de-Fonds (CH)
(72) Inventeur: Behbahanizadeh, Kambiz, 2300 La Chaux-de-Fonds (CH)
(74) Mandataire: Nithardt, Roland
(86) Numéro de dépôt international: CH9900305
(87) Numéro de publication internationale: WO0003481

(56) Documents cités:
- EP-A- 0 353 164
- US-A- 4 465 994

## Description

### Domaine technique

La présente invention concerne un dispositif de réglage automatique d'un composant d'une carte électronique, notamment d'un potentiomètre, comportant un multimètre associé à des moyens de réglage dudit composant.

### Technique antérieure

Les appareils électriques utilisés couramment sont de plus en plus souvent pourvus de composants électroniques montés sur des circuits imprimés ou cartes électroniques. Ces composants sont notamment des potentiomètres, tels que celui décrit par le brevet US 4 465 994, qui sont par définition des résistances variables devant être réglées à des valeurs très précises. Les réglages de tous ces composants se font pratiquement toujours manuellement et sont difficiles et longs à effectuer pour obtenir la valeur de réglage requise. De plus, avec les moyens actuellement utilisés, ces réglages manquent souvent de précision. La durée de cette étape de fabrication des cartes électroniques augmente donc le coût de fabrication desdites cartes et par conséquent leur prix de vente et celui des appareils auxquels elles sont destinées.

On connaît des multimètres programmables qui sont utilisés pour tester les composants électroniques des cartes et qui affichent les valeurs de leurs différents composants. Il existe également des outils de réglage automatique de potentiomètres dont le fonctionnement est basé sur la mesure de la différence entre la valeur de sortie et la valeur de réglage requise. En outre, on connaît, notamment par la publication EP 353 164 ayant pour objet un appareil destiné à la reproduction du son, une façon de commander des résistances variables, permettant le contrôle du volume, par un moteur à partir de données déterminées. Cependant aucun de ces appareils ou méthode ne permet d'effectuer des réglages rapides et très précis.

### Exposé de l'invention

La présente invention se propose de pallier les inconvénients de l'art antérieur en offrant un dispositif qui permet de régler rapidement et de manière très précise et semi-automatique les potentiomètres des cartes électroniques, qui est peu encombrant et qui est facile à utiliser.

Ce but est atteint par le dispositif tel que défini en préambule et caractérisé ledit multimètre comporte des moyens agencés pour recevoir et mémoriser les données de réglage dudit composant et commander les moyens de réglage auxquels il est associé en fonction desdites données.

De façon avantageuse, le multimètre est agencé pour recevoir et mémoriser les données de réglage du composant transmises par des moyens informatiques de traitement de données et les données transmises au multimètre sont définies par rapport aux paramètres du composant à régler et stockées sur un support de données.

Le multimètre est avantageusement à commande numérique.

Dans la forme de réalisation préférée du dispositif, les moyens de réglage du composant comportent un boîtier formant le manche d'un tournevis et une tige de réglage solidaire d'une des faces dudit boîtier.

Ladite tige de réglage est entraînée automatiquement par un servomoteur commandé par les données de réglage mémorisées et logé dans ledit boîtier.

De préférence, le boîtier comporte un écran d'affichage de la valeur du réglage à effectuer et des touches de commande desdits moyens de réglage.

Dans cette forme de réalisation préférée, les moyens de commande du servomoteur sont analogiques et numériques.

Les moyens de réglage sont avantageusement liés au multimètre pendant leur utilisation.

### Description sommaire des dessins

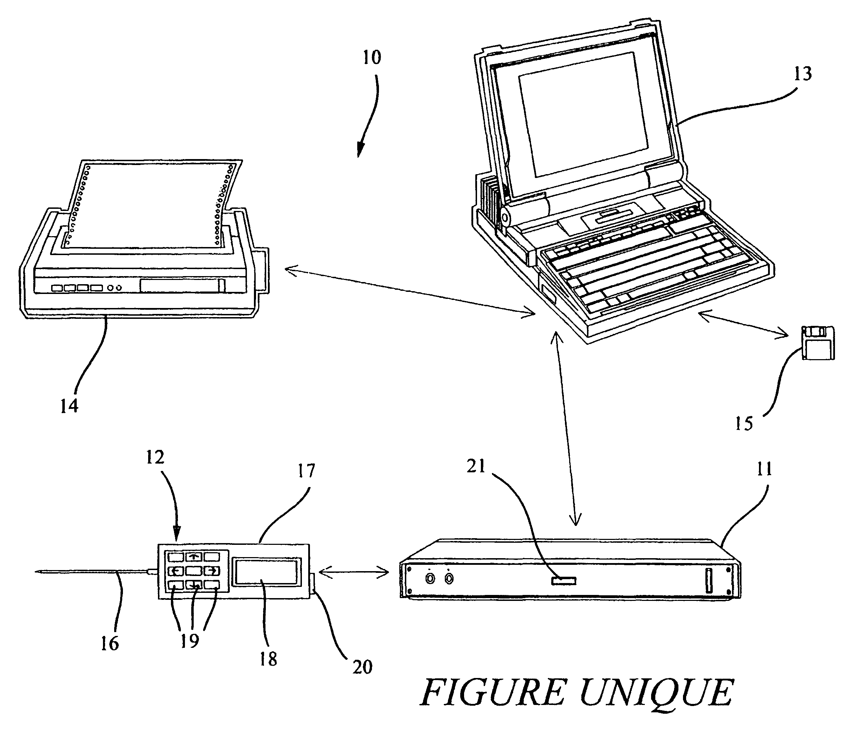

La présente invention sera mieux comprise en référence à la description d'un mode de réalisation préféré donné à titre d'exemple non limitatif et au dessin annexé dans lequel la figure unique représente de façon schématique le dispositif selon l'invention.

### Meilleure manière de réaliser l'invention

Le dispositif 10, tel que représenté par la figure, comporte un multimètre 11 relié d'une part à des moyens de réglage sous la forme d'un tournevis 12 et d'autre part à des moyens informatiques de saisie de données tels qu'un ordinateur 13. Une imprimante 14 et un support de données sous la forme d'une disquette 15 sont par ailleurs liés à l'ordinateur 13.

Le tournevis 12 se compose une tige de réglage 16 solidaire d'un manche se présentant sous la forme d'un boîtier parallélépipédique allongé 17. Ledit boîtier est pourvu, sur une de ses faces longitudinales, d'un écran d'affichage des données 18, de touches de commande 19 et, sur sa face d'extrémité opposée à la face portant la tige 16, d'une touche d'actionnement 20. Il est en outre agencé pour renfermer un servomoteur couplé à la tige 16 et commandé par les données mémorisées. Un câble de connexion solidaire d'une des faces du boîtier permet le raccordement du tournevis 12 au multimètre 11.

Le multimètre 11 est un appareil à commande numérique et programmable au moyen de l'ordinateur 13 et de la disquette 15 sur laquelle est mémorisé un logiciel de programmation approprié. Il se présente, dans l'exemple décrit sous la forme d'un élément parallélépipédique pourvu, sur une de ses faces, d'entrées analogiques et de sorties digitales synchronisées entre elles ainsi que de sorties relais synchronisées avec un nombre correspondant de sorties digitales. Il est en outre pourvu sur une de ses faces d'un connecteur 21 permettant sa liaison avec le boîtier 17 du tournevis 12. Une liaison du type RS232 le relie à l'ordinateur 13.

Le logiciel de programmation du multimètre 11, qui a été développé pour le dispositif de l'invention, peut être utilisé avec n'importe quel ordinateur du type PC tournant par exemple sous WINDOWS 95 ®. Ce logiciel est formé d'une suite d'étapes successives numérotées parmi lesquelles on sélectionne les étapes nécessaires au réglage du composant concerné pour former une boucle d'exécution qui sera transmise au multimètre 11 puis exécutée par les moyens de réglage 12. Il permet en outre de sélectionner séparément chaque entrée/sortie relais ou sortie digitale du multimètre 11.

L'utilisation du dispositif de réglage 10 de l'invention se fait de la façon suivante :

Dans un premier temps, on raccorde le tournevis 12 au multimètre 11, ce dernier à l'ordinateur 13 par la liaison RS232 prévue à cet effet et on charge dans ledit ordinateur le logiciel stocké sur la disquette 15.
- Lorsque le logiciel est installé, pour le réglage de potentiomètres
   a/ on définit les paramètres de réglage, à savoir :
      l'échelle dans laquelle se trouve la valeur à régler, par exemple 200 Ω, 2kΩou 20 kΩ,
      la valeur précise de la résistance voulue,
      la tolérance acceptée sur cette valeur de réglage,
      la direction dans laquelle le tournevis doit tourner ainsi que le type du potentiomètre à régler (potentiomètre a un ou plusieurs tours de réglage),
   b/ on définit le point final de la boucle d'exécution,
   c/ on sauvegarde les données transmises sur un support de données tel que le disque dur de l'ordinateur 13, et
   d/ on transfère ces données au multimètre 11.

Dans un deuxième temps, lorsque cette sauvegarde et ce transfert ont été effectués, et que le message de validation correspondant a été affiché par l'écran 18, le tournevis se trouve en mode d'exécution.

Ensuite, pour effectuer une série de réglages, on procède comme suit :
- on introduit la tige 16 du tournevis dans la fente de réglage du potentiomètre à régler,
- on appuie sur la touche d'actionnement 20 permettant le démarrage de la boucle d'exécution mémorisée,
- sous l'action du servomoteur commandé par la boucle d'exécution mémorisée, la tige 16 tourne automatiquement de la portion de tour ou du nombre de tours nécessaires pour amener le potentiomètre à la valeur voulue,
- lorsque cette valeur est atteinte dans la tolérance programmée pendant au moins une seconde, un témoin prévu à cet effet, sous la forme d'une diode électroluminescente, d'un message digital, ou de tout autre élément similaire connu, indique que le réglage est bon,
- on retire alors la tige 16 du tournevis tout en relâchant la touche d'actionnement 20. Ce relâchement de la touche fait passer la boucle à la prochaine étape.
- on place ensuite le tournevis dans le potentiomètre suivant et on procède à un nouveau réglage.

L'imprimante 14 liée à l'ordinateur 13 permet l'impression des données de réglage introduites initialement par l'utilisateur.

Toutes ces opérations se font rapidement étant donné qu'à chaque dernière étape d'un réglage la bouche d'exécution s'initialise et revient automatiquement à la première étape. Les réglages obtenus sont très précis, ce qui est très appréciable dans une chaîne de fabrication de cartes électroniques.

Le tournevis peut fonctionner en exécution automatique du programme mémorisé ou en défilement manuel des étapes du programme à l'aide de touches de commande prévues à cet effet. Ce défilement manuel permet par exemple une modification de la boucle programmée.

### Possibilités d'application industrielle

Le dispositif selon l'invention, qui permet de régler rapidement et de manière très précise et semi-automatique les potentiomètres des cartes électroniques, est peu encombrant et facile à utiliser. De plus, étant donné son faible encombrement, il peut être implanté sans problèmes dans toutes les chaînes de montage.

Il peut également être utilisé comme dispositif de test des composants d'une carte ou d'un appareil électronique en effectuant par exemple des mesures de valeurs des résistances ou des mesures de la tension appliquée aux bornes d'entrée des divers éléments.

Le principe de fonctionnement et les différentes étapes d'exécution de cette forme d'utilisation sont identiques à ceux décrits en référence à l'utilisation en tant que dispositif de réglage. Pour démarrer un test et obtenir le résultat de ce test on agit sur la touche de commande du boîtier 17 prévue à cet effet.

Toutes les opérations de programmation du multimètre peuvent se faire en temps réel. En outre, le logiciel utilisé dans le dispositif peut être stocké directement sur le disque dur de l'ordinateur. Il est également possible d'introduire dans le dispositif une boîte d'extension du nombre d'entrées/sorties dudit multimètre. Dans une variante de réalisation il est possible de prévoir l'intégration du multimètre dans les moyens de réglage.

## Revendications

1. Dispositif de réglage automatique d'un composant d'une carte électronique, notamment d'un potentiomètre, comportant un multimètre (11) associé à des moyens de réglage dudit composant, **caractérisé en ce que** ledit multimètre (11) comporte des moyens agencés pour recevoir et mémoriser les données de réglage dudit composant et commander les moyens de réglage auxquels il est associé en fonction desdites données.

2. Dispositif selon la revendication 1, **caractérisé en ce que** le multimètre (11) est agencé pour recevoir et mémoriser les données de réglage du composant transmises par des moyens informatiques de traitement de données (13).

3. Dispositif selon la revendication 2, **caractérisé en ce que** les données transmises au multimètre (11) sont définies par rapport aux paramètres du composant à régler et stockées sur un support de données (15).

4. Dispositif selon la revendication 1, **caractérisé en ce que** le multimètre (11) est à commande numérique.

5. Dispositif selon la revendication 1, **caractérisé en ce que** les moyens de réglage du composant comportent un boîtier (17) formant le manche d'un tournevis (12) et une tige de réglage (16) solidaire d'une des faces dudit boîtier.

6. Dispositif selon la revendication 5, **caractérisé en ce que** tige de réglage (16) est entraînée automatiquement par un servomoteur commandé par les données de réglage mémorisées.

7. Dispositif selon la revendication 6, **caractérisé en ce que** le servomoteur est logé dans ledit boîtier (17).

8. Dispositif selon la revendication 5, **caractérisé en ce que** le boîtier (17) comporte un écran d'affichage (18) de la valeur du réglage à effectuer et des touches de commande (19, 20) desdits moyens de réglage.

9. Dispositif selon la revendication 6, **caractérisé en ce que** les moyens de commande du servomoteur sont analogiques et numériques.

10. Dispositif selon la revendication 1, **caractérisé en ce que** les moyens de réglage sont liés au multimètre (11) pendant leur utilisation.

## Patentansprüche

1. Automatische Regelungsvorrichtung für ein Bauteil einer elektronischen Karte, insbesondere ein Potentiometer, mit einem Multimeter (11), das mit Regelungsmitteln des Bauteils verbunden ist,
**dadurch gekennzeichnet, daß**
das Multimeter (11) Mittel umfaßt, die dafür vorgesehen sind, Regelungsdaten des Bauteils zu empfangen und zu speichern und die Regelungsmittel, mit denen sie verbunden sind, in Abhängigkeit von den Daten zu steuern.

2. Vorrichtung nach Anspruch 1,
**dadurch gekennzeichnet, daß**
das Multimeter (11) dafür vorgesehen ist, von Informatik-Datenverarbeitungsmitteln (13) übertragene Regelungsdaten von dem Bauteil zu empfangen und zu speichern.

3. Vorrichtung nach Anspruch 2,
**dadurch gekennzeichnet, daß**
die zu dem Multimeter (11) übertragenen Daten im Verhältnis zu den zu regelnden Parametern des Bauteils definiert sind und auf einem Datenträger (15) gespeichert werden.

4. Vorrichtung nach Anspruch 1,
**dadurch gekennzeichnet, daß**
das Multimeter (11) eine numerische Steuerung ist.

5. Vorrichtung nach Anspruch 1,
**dadurch gekennzeichnet, daß**
die Regelungsmittel des Bauteils ein Gehäuse (17), das den Handgriff eines Schraubenziehers (12) bildet, sowie eine mit einer der Seiten des Gehäuses fest verbundene Regelungsstange (16) umfassen.

6. Vorrichtung nach Anspruch 5,
**dadurch gekennzeichnet, daß**
die Regelungsstange (16) automatisch durch einen von den gespeicherten Regelungsdaten gesteuerten Stellmotor angetrieben wird.

7. Vorrichtung nach Anspruch 6,
**dadurch gekennzeichnet, daß**
der Servomotor in dem Gehäuse (17) untergebracht ist.

8. Vorrichtung nach Anspruch 5,
**dadurch gekennzeichnet, daß**
das Gehäuse (17) eine Bildschirmanzeige (18) des einzustellenden Regelungswertes, und Steuerungstasten (19,20) der Regelungsmittel umfaßt.

9. Vorrichtung nach Anspruch 6,
**dadurch gekennzeichnet, daß**
die Steuerungsmittel des Servomotors analog und numerisch sind.

10. Vorrichtung nach Anspruch 1,
**dadurch gekennzeichnet, daß**
die Regelungsmittel während ihrer Verwendung mit dem Multimeter (11) verbunden sind.

## Claims

1. A device for the automatic adjustment of a component on an electronic card, specifically a potentiometer, comprising a multimeter (11) associated with a means for adjusting said component, **characterized in that** said multimeter (11) comprises a means designed to receive and store the adjustment data for said component and to control the adjustment means with which it is associated as a function of said data.

2. A device according to claim 1, **characterized in that** the multimeter (11) is designed to receive and store the adjustment data for a component transmitted by a data processing device (13).

3. A device according to claim 2, **characterized in that** the data transmitted to the multimeter (11) is defined in relation to the parameters of the component to be adjusted and it is stored on a data medium (15).

4. A device according to claim 1, **characterized in that** the multimeter (11) is of a numerical control.

5. A device according to claim 1, **characterized in that** the means for adjusting the component comprises a housing (17) forming the handle of a screwdriver (12) and an adjusting rod (16) integral with one of the surfaces of said housing.

6. A device according to claim 5, **characterized in that** the adjusting rod (16) is driven automatically by a servomotor controlled by the stored adjustment data.

7. A device according to claim 6, **characterized in that** the servomotor is disposed in said housing (17).

8. A device according to claim 5, **characterized in that** the housing (17) comprises a screen (18) for displaying the adjustment value to be effected and a keypad (19, 20) for controlling said adjustment means.

9. A device according to claim 6, **characterized in that** the means for controlling the servomotor are analog and digital.

10. A device according to claim 1, **characterized in that** the adjustment means is connected to the multimeter (11) during use.
